# EUROPEAN PATENT APPLICATION

(11) **EP 2 562 791 A1**
(43) Date of publication of application: **27.02.2013**
(21) Application number: 11772076.3
(22) Date of filing: 21.04.2011
(51) Int. Cl.: H01L 21/22, H01L 21/225, H01L 21/383, H01L 31/04

(54) **METHOD FOR PRODUCING SEMICONDUCTOR DEVICE**

(30) Priority: 23.04.2010 JP 2010099762
(71) Applicant: Sharp Kabushiki Kaisha, Osaka-shi, Osaka 545-8522 (JP)
(72) Inventor: KOHIRA, Masatsugu, Osaka-shi, Osaka 545-8522 (JP)
(74) Representative: Müller - Hoffmann & Partner
(86) International application number: PCT/JP2011/059845
(87) International publication number: WO 2011/132744

(57) **Abstract**

A method for manufacturing a semiconductor device includes the step of forming a mask (31) by application of a masking ink (24) to a semiconductor substrate (10) and the step of forming a diffusion layer (12, 13). The method includes at least one of the step of heating the masking ink (24) and the step of irradiating the masking ink (24) with light, at at least one of a timing before, a timing during, and a timing after the application of said masking ink (24).

## Description

### TECHNICAL FIELD

The present invention relates to a method for manufacturing a semiconductor device.

### BACKGROUND ART

In recent years, in view of global environmental problems such as the problem of energy resource exhaustion and the increase of CO₂ in the atmosphere, development of clean energies has been called for. Solar photovoltaic power generation particularly by means of a solar cell among semiconductor devices has been developed and brought into practical use, and is now following the path of development so as to provide a new energy source.

Among solar cells, double-sided-contact solar cells have conventionally been in the mainstream. The double-sided-contact solar cell is manufactured, for example, by diffusing, in a light-receiving surface of a single-crystalline or polycrystalline silicon substrate, an impurity of a conductivity type opposite to the conductivity type of the silicon substrate to thereby form a pn junction, and forming electrodes respectively on the light-receiving surface of the silicon substrate and the back surface opposite to the light-receiving surface. Regarding the double-sided-contact solar cells, it is common to diffuse, in the back surface of the silicon substrate, an impurity of the same conductivity type as that of the silicon substrate in such a manner that the impurity is diffused at a high concentration, so as to increase the output power using the back surface field effect.

Research and development is also being promoted of back electrode type solar cells in which a light-receiving surface of a silicon substrate has no electrode formed thereon while only the back surface has electrodes formed thereon (see for example PTL 1 (Japanese Patent Laying-Open No. 2007-049079)).

### CITATION LIST

### PATENT LITERATURE

PTL 1: Japanese Patent Laying-Open No. 2007-049079

### SUMMARY OF INVENTION

### TECHNICAL PROBLEM

In order to improve the characteristics of the back electrode type solar cell disclosed in PTL 1, it is preferable to form a p-type dopant diffusion layer and an n-type dopant diffusion layer in the back surface of the silicon substrate so that the diffusion layers each have a fine line width. In order to achieve such fine lines, it is necessary to precisely form a mask, which is adapted to control diffusion (hereinafter diffusion control mask), outside a desired dopant diffusion region.

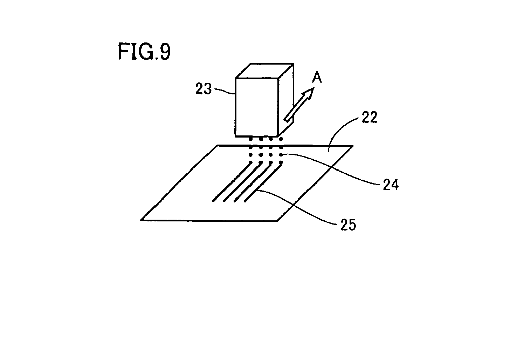

In the case, however, where such a mask is formed from a masking ink containing a solvent, a spread of the masking ink may be generated on the surface of the silicon substrate and accordingly the line may be formed wider than a desired thin line. Specifically, as shown in Fig. 9, in the case where the masking ink is applied by the inkjet method, while an inkjet head 23 is moved above a semiconductor substrate 22 in the direction for example indicated by an arrow A in Fig. 9, ink 24 is applied onto semiconductor substrate 22 to form thin lines 25. However, since the surface of the semiconductor substrate is hydrophobic, affinity for the ink may cause a spread of thin line 25. Moreover, since the mechanism of discharging the ink from inkjet head 23 imposes a restriction on the viscosity of the ink, a thick mask is difficult to form, resulting in inadequate diffusion control function in some cases.

Thus, if the p-type dopant diffusion layer and the n-type dopant diffusion layer are each formed to have a large line width or the mask cannot be made thick, a resultant problem is that desired dopant diffusion layers fail to be formed and therefore the back electrode type solar cell having significantly degraded characteristics is an off-specification product.

This problem is not only of the back electrode type solar cell but also common to other semiconductor devices that require doped diffusion layers in the form of thin lines.

### SOLUTION TO PROBLEM

The present invention has been made in view of the above problem to provide a method for manufacturing a semiconductor device by which degradation of the characteristics of the semiconductor device can stably be suppressed.

Specifically, the method for manufacturing a semiconductor device of the present invention includes the steps of: forming a mask by application of a masking ink to a semiconductor substrate; and forming a diffusion layer, and the method includes at least one of the step of heating the masking ink and the step of irradiating the masking ink with light, at at least one of a timing before, a timing during, and a timing after the application of the masking ink.

According to the present invention, the step of heating includes heating the semiconductor substrate.

The semiconductor substrate is preferably a silicon substrate. The masking ink preferably contains at least one of an SiO₂ precursor and a TiO₂ precursor. Here, the masking ink preferably contains at least one of a photo-setting resin and a thermosetting resin.

The method for manufacturing a semiconductor device of the present invention includes the step of baking the masking ink after the step of heating the masking ink or the step of irradiating the masking ink with light.

### ADVANTAGEOUS EFFECTS OF INVENTION

The method for manufacturing a semiconductor device of the present invention includes one of the step of heating the masking ink and the step of irradiating the masking ink with light, at at least one of a timing before, a timing during, and a timing after the application of the masking ink, and therefore can precisely form doped regions in the form of thin lines in the semiconductor substrate. Accordingly, degradation of the characteristics of the semiconductor device including this semiconductor substrate can be suppressed.

### BRIEF DESCRIPTION OF DRAWINGS

Fig. 1 is a schematic cross sectional view of an example of a back electrode type solar cell of the present invention.
Fig. 2 (a) to Fig. 2 (i) are schematic cross sectional views illustrating an example of the method for manufacturing the back electrode type solar cell in Fig. 1.
Fig. 3 (a) and Fig. 3 (b) are schematic diagrams illustrating how to apply and heat a masking ink of the present invention.
Fig. 4 (a) is a diagram showing the actually measured values of the height and the width of a mask formed on a semiconductor substrate in Reference Example 1, and Fig. 4 (b) is a diagram showing the actually measured values of the height and the width of a mask formed on a semiconductor substrate in Reference Example 2.
Fig. 5 (a) is a diagram showing the actually measured values of the height and the width of a mask formed on a semiconductor substrate in Reference Example 3, Fig. 5 (b) is a diagram showing the actually measured values of the height and the width of a mask formed on a semiconductor substrate in Reference Example 4, and Fig. 5 (c) is a diagram showing the actually measured values of the height and the width of a mask formed on a semiconductor substrate in Reference Example 5.
Fig. 6 is a schematic plan view of an example of the back surface of a back electrode type solar cell fabricated in accordance with an example of the manufacturing method of the present invention.
Fig. 7 is a schematic plan view of another example of the back surface of a back electrode type solar cell fabricated in accordance with an example of the manufacturing method of the present invention.
Fig. 8 is a schematic plan view of still another example of the back surface of a back electrode type solar cell fabricated in accordance with an example of the manufacturing method of the present invention.
Fig. 9 is a schematic diagram illustrating how to apply a masking ink by a conventional inkjet method.

### DESCRIPTION OF EMBODIMENTS

In the following, embodiments of the present invention will be described. In the drawings of the present invention, the same reference characters denote the same components or corresponding components.

### <First Embodiment: Heating + Diffusion>

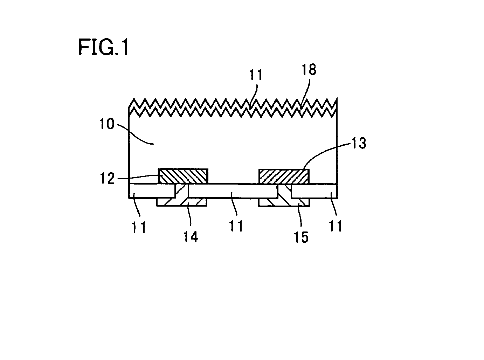

Fig. 1 shows a schematic cross sectional view of an example of a back electrode type solar cell which is an example of the semiconductor device of the present invention. Here, the back electrode type solar cell shown in Fig. 1 includes: a semiconductor substrate 10; a first-conductivity-type dopant diffusion layer 12 and a second-conductivity-type dopant diffusion layer 13 spaced from each other in one surface of semiconductor substrate 10; passivation films 11 formed respectively on this one surface of semiconductor substrate 10 and on a textured structure 18 which forms the other surface of semiconductor substrate 10; and an electrode for first conductivity type 14 and an electrode for second conductivity type 15 electrically connected to first-conductivity-type dopant diffusion layer 12 and second-conductivity-type dopant diffusion layer 13 respectively.

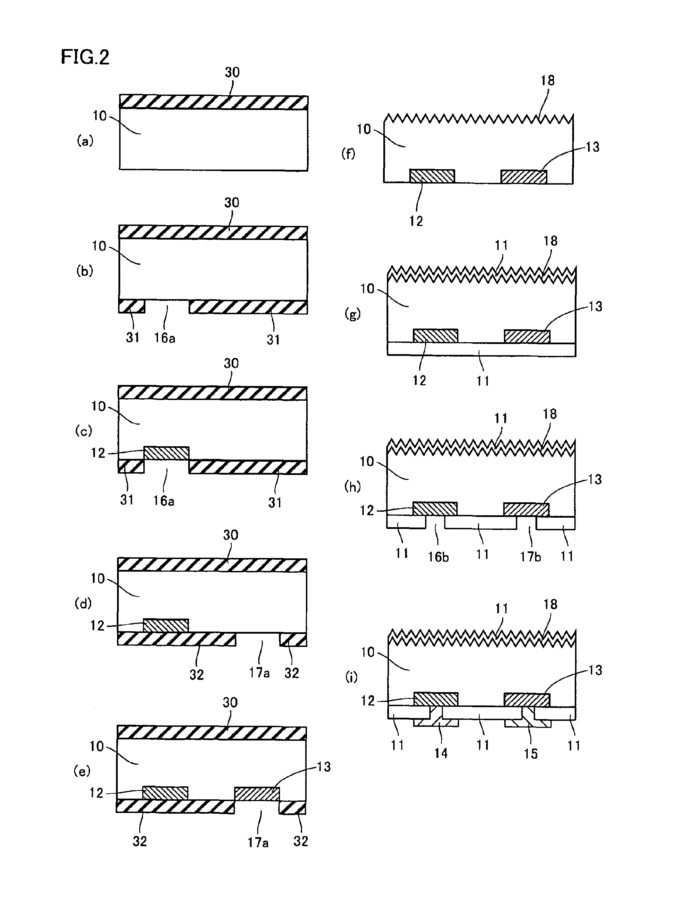

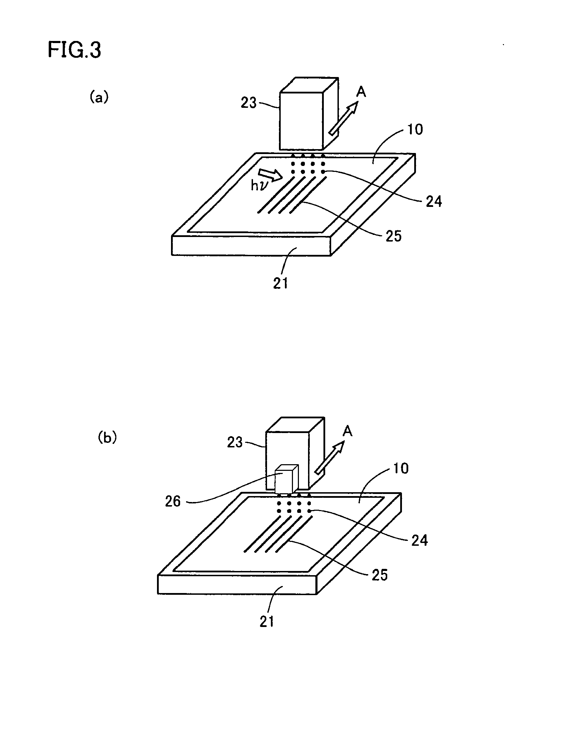

In the following, with reference to the schematic cross sectional views in Fig. 2 (a) to Fig. 2 (i) and the schematic diagrams in Fig. 3 (a) and Fig. 3 (b), a description will be given of an example of the method for manufacturing the solar cell shown in Fig. 1 which is an example of the semiconductor device of the present invention.

First, as shown in Fig. 2 (a), semiconductor substrate 10 is prepared and a masking ink is applied to the whole of the surface which is to serve as a light-receiving surface (this surface may hereinafter be referred to simply as "light-receiving surface") to form a mask 30.

Examples of this semiconductor substrate 10 may include a silicon substrate, a substrate made of a compound semiconductor such as silicon carbide, gallium arsenide, and gallium nitride, and the like. In the case where the silicon substrate is used as semiconductor substrate 10, a slicing-induced damage caused by slicing of a silicon ingot may be removed from the silicon substrate to be used. This slicing-induced damage may be removed for example by etching the surface of the silicon substrate having been sliced from the ingot, by means of a mixed acid of hydrogen fluoride aqueous solution and nitric acid or an alkali aqueous solution such as sodium hydroxide.

The size and the shape of semiconductor substrate 10 are not particularly limited. For example, the substrate may have a thickness of not less than 100 µm and not more than 300 µm, and have a surface in the shape of a quadrilateral with a length of one side of not less than 100 mm and not more than 200 mm or have a circular shape which is used for the so-called electronic device.

As the masking ink for forming the above-described mask 30, any ink that is used when known masks are formed may be employed. Moreover, since the masking ink is applied to the entire light-receiving surface, the method for applying the masking ink is not particularly limited. Thus, the masking ink may be applied by screen printing or spin coat, or applied by means of a spray, for example. The thickness of mask 30 to be formed on the light-receiving surface side is not particularly limited as long as the mask functions properly as a mask, and may be set for example to 200 nm to 800 nm.

Depending on the type of the masking ink, this mask 30 may be formed by applying the masking ink, thereafter heating the whole semiconductor substrate 10 to dry the masking ink, and then firing the masking ink.

Next, as shown in Fig. 2 (b), to the surface of semiconductor substrate 10 that is opposite to the light-receiving surface side on which mask 30 is formed (the opposite surface may hereinafter be referred to simply as "back surface"), the masking ink is applied and dried so that an opening 16a is partially formed, so as to form a mask 31 for control diffusion. This diffusion control mask 31 is a film that has a control function which suppresses diffusion of a dopant. Only in the region where the mask is not formed by the masking ink on the semiconductor substrate (the region may hereinafter be referred to simply as "doped region"), diffusion of a dopant occurs. Thus, the masking ink is used to form diffusion control mask 31 and thereby enable a doped region and a region where no dopant is diffused to be produced easily. Accordingly, finely patterned n-type doped regions and p-type doped regions can be formed easily.

The present invention is characterized by that the step of forming diffusion control mask 31 provided on the back surface of semiconductor substrate 10 as described above includes one of the step of heating the masking ink and the step of irradiating the masking ink with light, at at least one of a timing before, a timing during, and a timing after the application of the masking ink to semiconductor substrate 10. One of the step of heating the diffusion control masking ink and the step of irradiating the masking ink with light is included, and accordingly mask 31 which is formed by the masking ink can be shaped in the form of a thin line and a thick film.

According to the present invention, examples of the method for applying the masking ink may include application based on the inkjet method, application with a spray, application with a dispenser, and the like. In the case of these application methods, it is preferable, in terms of the efficiency in discharging the ink, to adjust the viscosity of the masking ink to a range of not less than 5 mPa·s and not more than 25 mPa·s at room temperature (25°C), which is more preferably a range of not less than 10 mPa·s and not more than 20 mPa·s.

In the case where the above-described masking ink is used, the conventional method for forming a mask cannot form mask 31 having a thickness for example of 500 nm in one step of applying the ink, and therefore requires to perform the step of applying the ink multiple times. In such a case, it is difficult to perform the application step multiple times so that the ink is applied precisely to the same location. Thus, it has been difficult to keep the line width of mask 31 constant.

In contrast, since the present invention includes one of the step of heating the masking ink for forming diffusion control mask 31 and the step of irradiating the masking ink with light as described above, the present invention can form diffusion control mask 31 in the shape of a thin line with a line width for example of 100 µm or less. The upper limit of the line width may also be more than 100 µm. Furthermore, the diffusion control mask 31 can be formed to have a thickness of 500 nm or more in one step of applying the ink, even if the line width of the thin line is 100 µm or less. In addition, the interval between masks 31 adjacent to each other is preferably set to 50 µm to 1500 µm. In the case where the line width of diffusion control mask 31 is set to 100 µm or less, the manufacturing method of the present invention that causes no spread of the ink is particularly effective. If a dense pattern is not particularly required, the interval between masks 31 may be set larger than 100 µm for which the manufacturing method of the present invention is particularly effective as described above, or larger than 1500 µm.

According to the present invention, the step of heating the masking ink is the step of heating the masking ink to thereby prevent the masking ink from spreading on the back surface of semiconductor substrate 10. In the following, application of the masking ink based on the inkjet method will be described with reference to Fig. 3 (a) and Fig. 3 (b). In accordance with the inkjet method, ink 24 held in inkjet head 23 and discharged at a predetermined discharge pressure is applied onto semiconductor substrate 10. Inkjet head 23 is moved in the direction of arrow A in Fig. 3 (a) and Fig. 3 (b), so that the masking ink is applied in the form of thin lines 25 on semiconductor substrate 10 as shown in Fig. 3 (a) and Fig. 3 (b).

At this time, a heating apparatus such as a heater provided to a stage 21 on which semiconductor substrate 10 is mounted as shown in Fig. 3 (a) and Fig. 3 (b) may be used to heat semiconductor substrate 10 and thereby indirectly heat masking ink 24 having been applied. Semiconductor substrate 10 may entirely be heated. There is, however, a possibility that heat conduction from semiconductor substrate 10 to inkjet head 23 causes masking ink 24 to be heated before being discharged and accordingly causes the viscosity of ink 24 to be changed, which may influence the discharge characteristics. Therefore, as shown in Fig. 3 (a) and Fig. 3 (b), it is preferable to provide above-described stage 21 under semiconductor substrate 10 or on the opposite side to the surface to which ink 24 is applied, and to partially heat semiconductor substrate 10. Such heating as described above may be performed by heating semiconductor substrate 10 before application of masking ink 24, during application of masking ink 24, or immediately after application of masking ink 24.

Above-described heating of the masking ink may also be performed by heating the ink-applied surface to which the ink is applied, of semiconductor substrate 10 for example, instead of heating by means of stage 21 as shown in Fig. 3 (a) and Fig. 3 (b). Such heating of the ink-applied surface may be performed, for example as shown in Fig. 3 (b), by irradiating a region to which masking ink 24 has been applied with light from a light irradiation port 26 of a light irradiation apparatus provided to inkjet head 23. It should be noted, however, in the case where the ink-applied surface of semiconductor substrate 10 is to be heated, it is preferable, in order to prevent the heat conduction from influencing masking ink 24 before being discharged, to use a heating apparatus like a soldering iron capable of performing partial heating or use the light irradiation apparatus as shown in Fig. 3 (b) provided on the leading side of inkjet head 23, to thereby pre-heat the region where masking ink 24 is to be applied, immediately before application of the ink, or heat a portion in and around the region where masking ink 24 has been applied, immediately after application of the ink. Moreover, not only the manner of directly heating the semiconductor substrate or masking ink 24 as described above, but also the manner for example of raising, by a soldering iron or the like, the temperature of the ambient of the region where masking ink 24 has been discharged, may be used to still achieve the effects of the present invention.

Regarding the manufacturing method of the present invention, the above-described inkjet method or the like imposes a restriction on the viscosity of the ink before being discharged, since a certain ink discharge pressure is required. Therefore, it is not beneficial to heat masking ink 24 whose viscosity has been adjusted to a certain viscosity which is suitable for the ink to be discharged.

The above-described step of heating is preferably performed so that the temperature of the ink-applied surface of semiconductor substrate 10 is in a range of 40°C to 80°C, which is more preferably 50°C to 60°C. The time for which heating is done is not particularly limited.

Masking ink 24 for forming diffusion control mask 31 preferably contains at least one of an SiO₂ precursor and a TiO₂ precursor. The SiO₂ precursor is considered to normally exist in the form of Si(OH)₄ in masking ink 24 before being applied, and changes to SiO₂ in the step of drying to play a role as diffusion control mask 31. Other substances that form the SiO₂ precursor may include a substance such as TEOS (tetraethylorthosilicate) represented by a general formula: R¹ₙSi(OR²)₄₋ₙ (where R¹ is methyl group, ethyl group, or phenyl group, R² is methyl group, ethyl group, n-propyl group, or isopropyl group, and n is 0, 1, or 2), siloxane, polysiloxane, and the like. Examples of substances that form the TiO₂ precursor other than Ti(OH)₄ may include a substance such as TPT (tetraisopropoxy titanium) represented by R³ₙTi(OR⁴)₄₋ₙ (where R³ is methyl group, ethyl group, or phenyl group, R⁴ is methyl group, ethyl group, n-propyl group, or isopropyl group, and n is 0, 1, or 2), TiCl₄, TiF₄, TiOSO₄ and the like.

Regarding diffusion control mask 31 formed by masking ink 24, in the case where the ink contains at least one of an SiO₂ precursor and a TiO₂ precursor, its main component is SiO₂ and/or TiO₂. Here, in order to form mask 31 in the shape of a thin line and a thick film, the concentration of the SiO₂ precursor and/or the TiO₂ precursor in masking ink 24 is preferably 5% by mass to 30% by mass, and more preferably 10% by mass to 20% by mass.

Masking ink 24 which forms diffusion control mask 31 contains a solvent. As the solvent, any of known alcohols, ethers, and hydrophilic esters may be used so that the above-described efficiency in discharging ink is accomplished. Specifically, examples of the solvent may include: water; alcohols such as methanol, ethanol, and isopropyl alcohol; hydrophilic polyhydric alcohols such as ethylene glycol, methylcellosolve, methylcellosolve acetate, ethylcellosolve, diethylcellosolve, cellosolve acetate, ethylene glycol monophenyl ether, methoxymethoxy ethanol, ethylene glycol monoacetate, ethylene glycol diacetate, diethylene glycol, diethylene glycol monomethyl ether, diethylene glycol monoethyl ether acetate, diethylene glycol monobutyl ether, diethylene glycol monobutyl ether acetate, diethylene glycol dimethyl ether, diethylene glycol methylethyl ether, diethylene glycol diethyl ether, diethylene glycol acetate, triethyl glycol, triethylene glycol monomethyl ether, triethylene glycol monoethyl ether, tetraethylene glycol, liquid polyethylene glycol, propylene glycol, propylene glycol monomethyl ether, propylene glycol monoethyl ether, propylene glycol monobutyl ether, 1-butoxyethoxypropanol, dipropyl glycol, dipropylene glycol monomethyl ether, dipropylene glycol monoethyl ether, tripropylene glycol monomethyl ether, polypropylene glycol, trimethylene glycol, butanedial, 1,5-pentanedial, hexylene glycol, glycerin, glyceryl acetate, glycerin diacetate, glyceryl triacetate, trimethylolpropyne, 1,2,6-hexanetriol, and a hydrophilic derivative of these; aliphatic and aromatic polyhydric alcohols such as 1,2-propanediol, 1,5-pentanediol, and octanediol, an ester and an ether of these aliphatic and aromatic polyhydric alcohols; 1,2-butanediol, 1,4-butanediol, 1,3-butanediol, hydrophilic ethers such as dioxane, trioxane, tetrahydrofuran, and tetrahydropyran, methylal, diethylacetal, methylethylketone, methylisobutylketone, diethylketone, acetonylacetone, diacetone alcohol, hydrophilic esters such as methyl formate, ethyl formate, propyl formate, methyl acetate, and ethyl acetate. As the solvent, one of or a mixture of more than one solvent of the above-listed solvents may be used. It is especially preferable to use, as the solvent, butyl cellosolve, N-methyl-2-pyrrolidone, or a mixture of both butyl cellosolve and N-methyl-2-pyrrolidone.

Furthermore, masking ink 24 forming diffusion control mask 31 may also contain a known additive such as thickening agent. Since the thickening agent is used for adjusting the viscosity, the thickening agent may be dispensed with depending on the composition of ink 24. In the case where the thickening agent is used, any of the following may for example be used: ethyl cellulose, polyvinylpyrrolidone, bentonite, a rheology additive that is generally inorganic and used for a mixture of various polar solvents, nitrocellulose and other cellulose compounds, starch, gelatin, alginic acid, highly dispersive amorphous silicate such as Aerosil (registered trademark), polyvinylbutyral such as Mowital (registered trademark), sodium carboxymethyl cellulose, a thermoplastic polyamide resin such as Eurelon (registered trademark), organic castor oil derivative such as Thixin R (registered trademark), diamide wax such as Thixatrol plus (registered trademark), swelled polyacrylate such as Rheolate (registered trademark), polyether urea-polyurethane, polyether-polyol, and the like. It is, however, preferable to use ethyl cellulose, or polyvinylpyrrolidone, or a mixture of them. If the viscosity of ink 24 is too low, ink 24 may leak out from inkjet head 23. On the contrary, if the viscosity is too high, ink 24 hardly attaches to semiconductor substrate 10. Therefore, the concentration of the thickening agent in masking ink 24 which is to form diffusion control mask 31 is preferably set to 5% by mass to 15% by mass, and more preferably 8% by mass to 12% by mass, so that the viscosity of ink 24 is adjusted to the specific viscosity described above.

After masking ink 24 is applied in the form of a desired pattern, semiconductor substrate 10 is heated for example at 400 to 1000°C for 10 to 60 minutes to sinter SiO₂ contained in masking ink 24 and thereby form mask 31.

Next, as shown in Fig. 2 (c), from opening 16a of diffusion control mask 31, a first-conductivity-type dopant is diffused in the back surface of semiconductor substrate 10 to form first-conductivity-type dopant diffusion layer 12. The method for forming this first-conductivity-type dopant diffusion layer 12 may for example include vapor-phase diffusion, application diffusion by which a dopant diffusion agent is applied, and the like. First, the method for diffusing a dopant by means of the vapor-phase diffusion will be described. Semiconductor substrate 10 is placed in a furnace, and the first-conductivity-type dopant is diffused at 800 to 1000°C for 20 to 100 minutes, so that the first-conductivity-type dopant is diffused in semiconductor substrate 10, specifically in a region corresponding to opening 16a of diffusion control mask 31, and accordingly first-conductivity-type dopant diffusion layer 12 which is a high-concentration doped region is formed. Next, the application diffusion will be described. As the method for application, spin coat application, spray application, application with a dispenser, inkjet application, screen printing, relief printing, intaglio printing, lithography, or the like may be used. Following any of these methods, a first-conductivity-type dopant diffusion agent containing the first-conductivity-type dopant is diffused to the region corresponding to opening 16a and the substrate is held in a furnace of 800 to 1000°C for 20 to 100 minutes to thereby form first-conductivity-type dopant diffusion layer 12.

As the first-conductivity-type dopant diffusion agent, any agent containing a first-conductivity-type dopant source may be used. As the first-conductivity-type dopant source in the case where the first conductivity type is n type, one compound or two or more different compounds in combination containing phosphorous atoms such as phosphate, phosphorus oxide, diphosphorus pentaoxide, phosphate, or organic phosphorus compound, for example, may be used. As the first-conductivity-type dopant source in the case where the first conductivity type is p type, one compound or two or more different compounds in combination containing boron atoms and/or aluminum atoms such as boron oxide, boric acid, organic boron compound, boron-aluminum compound, organic aluminum compound, or aluminum salt for example, may be used.

As components of the first-conductivity-type dopant diffusion agent other than the first-conductivity-type dopant source, a solvent, a silane compound, a thickening agent, or the like may be used. Since the thickening agent is used for the purpose of adjusting the viscosity, the dopant diffusion agent may not contain the thickening agent.

Here, examples of the solvent may include water, methanol, ethanol, ethylene glycol monobutyl ether, diethylene glycol monobutyl ether, propylene glycol monomethyl ether, dipropylene glycol monomethyl ether, 1,2-propanediol, 1,4-butanediol, 1,3-butanediol, dioxane, trioxane, tetrahydrofuran, tetrahydropyran methylal, diethylacetal, methylethylketone, methylisobutylketone, diethylketone, acetonylacetone, diacetone alcohol, methyl formate, ethyl formate, propyl formate, methyl acetate, ethyl acetate, acetic anhydride, N-methyl pyrrolidone, and the like. As the solvent, one solvent or a mixture of two or more different solvents in combination may be used.

As the silane compound, the compound represented for example by the following general formula (I) may be used.

R⁵ₙSi(OR⁶)₄₋ₙ (I)

In the above general formula (I), R⁵ represents methyl group, ethyl group, or phenyl group. In the above general formula (I), R⁶ represents a straight-chain or branched-chain alkyl group having a carbon number of 1 to 4, such as methyl group, ethyl group, propyl group, isopropyl group, and butyl group. In the above general formula (I), n represents an integer of 0 to 4.

Examples of the silane compound represented by the above general formula (I) may include tetramethoxysilane, tetraethoxysilane, tetrapropoxysilane, tetrabutoxysilane, and salt of them (such as tetraethylorthosilicate). As the silane compound, one silane compound or a mixture of two or more different silane compounds in combination may be used.

Examples of the thickening agent may include castor oil, bentonite, nitrocellulose, ethylcellulose, polyvinyl pyrrolidone, starch, gelatin, alginic acid, amorphous silica, polyvinyl butyral, sodium carboxymethyl cellulose, polyamide resin, organic castor oil derivative, diamide wax, swelled polyacrylate, polyether urea-polyurethane, polyether-polyol, and the like. As the thickening agent, one thickening agent or two or more different thickening agents in combination may be used.

Subsequently, semiconductor substrate 10 may be immersed for example in an aqueous solution of hydrofluoric acid at a concentration of approximately 10% for about one minute to thereby remove diffusion control mask 31.

Next, as shown in Fig. 2 (d), to the back surface of semiconductor substrate 10, masking ink 24 is applied and dried so that an opening 17a is partially formed, so as to form a mask 32 for control diffusion. This mask 32 may be formed in a step and under conditions similar to those for diffusion control mask 31 (Fig. 2 (b)) provided for diffusing the first-conductivity-type dopant. Specifically, the step of forming diffusion control mask 32 includes the step of heating masking ink 24 at at least one of a timing before, a timing during, and a timing after application of masking ink 24 to semiconductor substrate 10, and accordingly mask 32 which is formed by masking ink 24 can be formed in the shape of a thin line and a thick film.

Subsequently, as shown in Fig. 2 (e), from opening 17a of diffusion control mask 32, a second-conductivity-type dopant having the conductivity type opposite to the first conductivity type is diffused in the back surface of semiconductor substrate 10 to form second-conductivity-type dopant diffusion layer 13. Second-conductivity-type dopant diffusion layer 13 may be formed by a similar method to the above-described method for forming first-conductivity-type dopant diffusion layer 12.

As to the first conductivity type and the second conductivity type, in the case where the first conductivity type is p type, the second conductivity type is n type and, in the case where the first conductivity type is n type, the second conductivity type is p type. As a p-type dopant, boron or aluminum for example may be used. As an n-type dopant, phosphorus for example may be used.

Subsequently, semiconductor substrate 10 is immersed for example in an aqueous solution of hydrofluoric acid at a concentration of approximately 10% for about one minute to thereby remove diffusion control mask 32 and mask 30.

Next, as shown in Fig. 2 (f), on the light-receiving surface of semiconductor substrate 10, textured structure 18 made up for example of pyramid-shaped depressions and protrusions or the like is formed. Textured structure 18 may be formed for example by etching the light-receiving surface of semiconductor substrate 10. Regarding etching of the light-receiving surface of semiconductor substrate 10, in the case where semiconductor substrate 10 is formed of a silicon substrate, an etching solution, which is for example an alkali aqueous solution such as sodium hydroxide or potassium hydroxide to which isopropyl alcohol is added, may be heated for example to a temperature of not lower than 70°C and not higher than 80°C and this etching solution may be used to etch the light-receiving surface of semiconductor substrate 10.

By way of example, semiconductor substrate 10 is kept at 75 to 85°C, 1 to 10% by mass of isopropyl alcohol is added as a surfactant to an aqueous solution of potassium hydroxide or the like so that 1 to 10% by mass aqueous solution of potassium hydroxide or sodium hydroxide is produced, this aqueous solution is increased in temperature to not lower than 70°C and not higher than 80°C as described above, and the light-receiving surface of semiconductor substrate 10 is immersed in this solution for 10 to 60 minutes, to thereby form textured structure 18 on the light-receiving surface. Alternatively, textured structure 18 may be formed by any known method such as a method using an aqueous solution of hydrazine or the like, as long as the method can form, on the light-receiving surface, textured structure 18 that suppresses reflection of the incident light.

While textured structure 18 may not be formed, it is preferable to form textured structure 18 in order to increase the amount of solar light that enters semiconductor substrate 10.

Next, as shown in Fig. 2 (g), passivation films 11 are formed respectively on the back surface where first-conductivity-type dopant diffusion layer 12 and second-conductivity-type dopant diffusion layer 13 of semiconductor substrate 10 are exposed, and on the light-receiving surface where textured structure 18 of semiconductor substrate 10 is formed. Passivation film 11 formed on the light-receiving surface is a film which functions as so-called antireflection film.

Here, as passivation film 11, a silicon oxide film, a silicon nitride film, or a stack of a silicon oxide film and a silicon nitride film, for example may be used. Passivation film 11 may be formed for example by the plasma CVD method, or the like.

Next, as shown in Fig. 2 (h), passivation film 11 on the back surface of semiconductor substrate 10 is partially removed to form a contact hole 16b and a contact hole 17b, so that a surface of first-conductivity-type dopant diffusion layer 12 is exposed from contact hole 16b and a surface of second-conductivity-type dopant diffusion layer 13 is exposed from contact hole 17b.

Here, contact hole 16b and contact hole 17b may be formed for example by a method according to which the photolithography technique is used to form, on passivation film 11, a resist pattern having openings in regions corresponding to the locations where contact hole 16b and contact hole 17b are to be formed respectively, and thereafter passivation film 11 is etched away from the openings of the resist pattern, or a method according to which an etching paste is applied to regions of passivation film 11 that correspond to locations where contact hole 16b and contact hole 17b are to be formed respectively, and thereafter the etching paste is heated to etch away passivation film 11.

As the etching paste, a paste containing phosphoric acid as an etching component, and containing, as components other than the etching component, water, an organic solvent, and a thickening agent, for example, may be used. As the organic solvent, at least one of ethylene glycol, ethylene glycol monobutyl ether, propylene carbonate, N-methyl-2 pyrrolidone, for example, may be used. As the thickening agent, at least one of cellulose, ethyl cellulose, cellulose derivative, nylon 6, and polyvinyl pyrrolidone, for example, may be used.

Next, as shown in Fig. 2 (i), electrode for first conductivity type 14 is formed that is electrically connected to first-conductivity-type dopant diffusion layer 12 through contact hole 16b, and electrode for second conductivity type 15 is formed that is electrically connected to second-conductivity-type dopant diffusion layer 13 through contact hole 17b.

Here, as electrode for first conductivity type 14 and electrode for second conductivity type 15, an electrode made of a metal such as silver may be used.

Thus, in accordance with the method for manufacturing a solar cell in the present embodiment, a back electrode type solar cell can be fabricated.

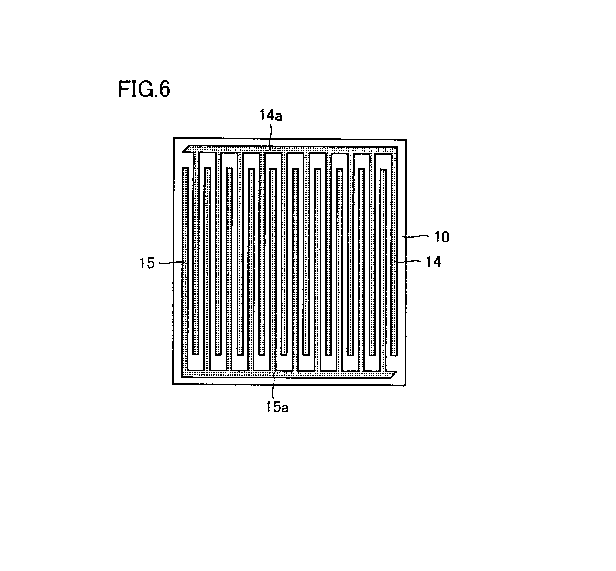

Fig. 6 shows a schematic plan view of an example of the back surface of a back electrode type solar cell fabricated in accordance with the manufacturing method of the present invention.

Here, as shown in Fig. 6, on the back surface of the back electrode type solar cell, a plurality of strip-shaped electrodes for first conductivity type 14 and a plurality of strip-shaped electrodes for second conductivity type 15 are arranged in such a manner that every single electrode for first conductivity type 14 and every single electrode for second conductivity type 15 are arranged alternately with a space therebetween. All electrodes for first conductivity type 14 are electrically connected to one strip-shaped power collecting electrode for first conductivity type 14a and all electrodes for second conductivity type 15 are electrically connected to one strip-shaped power collecting electrode for second conductivity type 15a.

Moreover, in the back surface of the back electrode type solar cell, high-concentration first-conductivity-type dopant diffusion layer 12 is located under each of a plurality of strip-shaped electrodes for first conductivity type 14, and second-conductivity-type dopant diffusion layer 13 is located under each of a plurality of strip-shaped electrodes for second conductivity type 15. The shape and the size of first-conductivity-type dopant diffusion layer 12 and second-conductivity-type dopant diffusion layer 13, however, are not particularly limited. For example, first-conductivity-type dopant diffusion layer 12 and second-conductivity-type dopant diffusion layer 13 may be strip-shaped along electrode for first conductivity type 14 and electrode for second conductivity type 15 respectively, or dot-shaped so that the diffusion layers contact respective parts of electrode for first conductivity type 14 and electrode for second conductivity type 15, respectively.

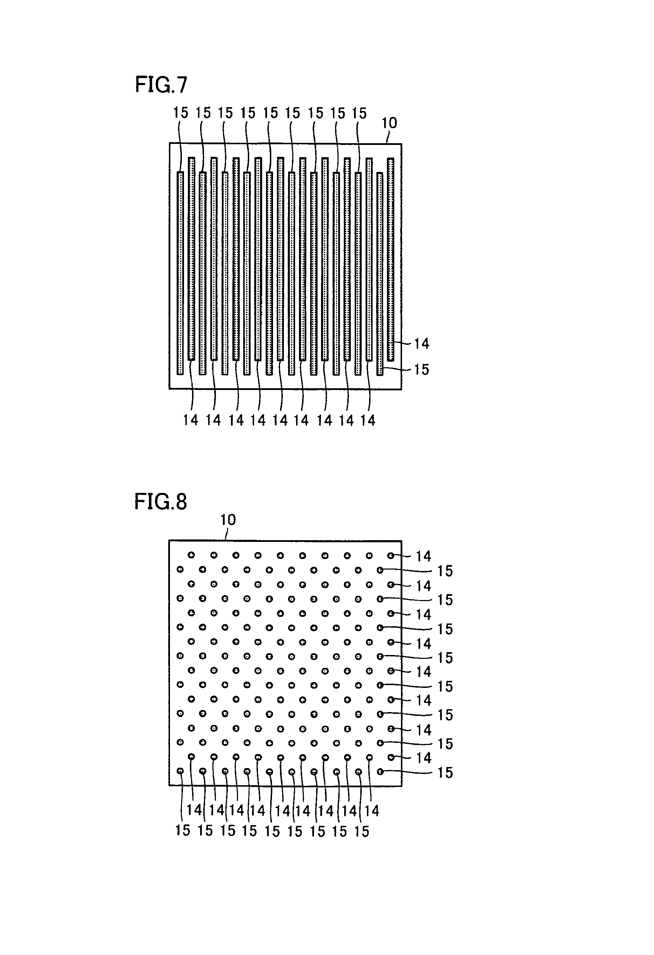

Fig. 7 shows a schematic plan view of another example of the back surface of a back electrode type solar cell fabricated in accordance with the manufacturing method of the present invention. Here, as shown in Fig. 7, electrodes for first conductivity type 14 and electrodes for second conductivity type 15 are formed in the shape of strips extending in the same direction (extending in the top-bottom direction in Fig. 7) and, on the back surface of semiconductor substrate 10, every single electrode for first conductivity type 14 and every single electrode for second conductivity type 15 are alternately arranged in the direction orthogonal to the above-described direction in which they extend.

Fig. 8 shows a schematic plan view of still another example of the back surface of a back electrode type solar cell fabricated in accordance with the manufacturing method of the present invention. Here, as shown in Fig. 8, electrode for first conductivity type 14 and electrode for second conductivity type 15 are each formed in the shape of dots. Every single line of dot-shaped electrode for first conductivity type 14 (extending in the top-bottom or left-right direction in Fig. 8) and every single line of dot-shaped electrode for second conductivity type 15 (extending in the top-bottom or left-right direction in Fig. 8) are arranged alternately on the back surface of semiconductor substrate 10.

While Fig. 2 (a) to Fig. 2 (i) show, for the sake of description, that only one first-conductivity-type dopant diffusion layer 12 and only one second-conductivity-type dopant diffusion layer 13 are formed in semiconductor substrate 10, it is apparent that actually a plurality of first-conductivity-type dopant diffusion layers 12 and a plurality of second-conductivity-type dopant diffusion layers 13 may be formed.

As described above by way of example, the present invention includes the step of heating masking ink 24 before, during, or after application of ink 24. Therefore, a spread of ink 24 on the back surface of semiconductor substrate 10 can be prevented that occurs in the case where masking ink 24 is applied to the back surface of semiconductor substrate 10 without being heated. Thus, the present invention can accurately form diffusion prevention masks 31 and 32 at desired positions of semiconductor substrate 10 and therefore, dopant diffusion layers 12 and 13 can also be formed accurately at desired positions. Accordingly, degradation of the characteristics of the semiconductor device such as solar cell can be suppressed.

### <Second Embodiment: Irradiation + Vapor Phase Diffusion>

Regarding a second embodiment, a description will be given of a method for manufacturing a semiconductor device that includes the step of irradiating masking ink 24 on the substrate with light, instead of the step of heating the substrate in the above-described first embodiment so that masking ink 24 is formed in the shape of thin lines. The steps of the method for manufacturing a semiconductor device except for the above-described step of irradiation with light are similar to those of the first embodiment, and the description thereof will not be repeated.

The step of irradiating masking ink 24 with light is included to heat ink 24 before and/or after being applied, with the heat generated from irradiation. Thus, masking ink 24 can be formed in the shape of a thin line and a thick film on semiconductor substrate 10. In the case where a heating apparatus provided to stage 21 shown in Fig. 3 (a) and Fig. 3 (b) is used for heating, it is preferable to include the step of heating by irradiation with light, by which partial heating can be done more delicately, in order to avoid influence of heat on inkjet head 23.

Regarding irradiation with light of the present invention, irradiation with light by a laser, irradiation with light by a halogen lamp, or the like may be used. An apparatus used for such irradiation with light may be a conventionally known apparatus provided so that the apparatus is located on the leading side or the following side of inkjet head 23, or provided at a position where the apparatus can heat the back surface of semiconductor substrate 10, separately from inkjet head 23.

In the case where the step of irradiating with light is included, masking ink 24 which forms diffusion control masks 31, 32 preferably contains a thermosetting resin as described below.

As such a thermosetting resin, a thermosetting resin in the form of fine particles having a particle size in a range of 1 µm to 10 µm for example is preferably used in terms of the viscosity.

The thermosetting resin is contained in masking ink 24 and, before masking ink 24 discharged from inkjet head 23 is applied onto semiconductor substrate 10, masking ink 24 is irradiated with light to thereby cure the thermosetting resin. Therefore, the viscosity of masking ink 24 can be made higher than that of masking ink 24 at the time when it is discharged. In order to reduce a spread of ink 24 which occurs when ink 24 discharged from inkjet head 23 drops on semiconductor substrate 10, it is preferable to set the concentration of the thermosetting resin in masking ink 24 to 1% by mass to 20% by mass, more preferably 3% by mass to 10% by mass, which may, however, vary depending on the thermosetting resin. Moreover, in order to apply the ink without causing spread, it is preferable to use, for ink 24, a laser whose output is set to 1000 W/cm² to 5000 W/cm², and irradiate masking ink 24 discharged from inkjet head 23 for a period of not shorter than 0.5 seconds and not longer than 5 seconds, before the ink is applied to semiconductor substrate 10 or immediately after the ink is applied to semiconductor substrate 10 (see Fig. 3 (b)).

Instead of the thermosetting resin or together with the thermosetting resin, a photo-setting resin may be contained in masking ink 24. In this case, it is preferable to perform UV irradiation instead of the above-described irradiation by a laser, irradiation by a halogen lamp, or the like.

The second embodiment includes the step of irradiating diffusion control masking ink 24 with light, and therefore can form diffusion control masks 31, 32 so that their line width is 100 µm or less. The upper limit of the line width of diffusion control masks 31, 32 may also be larger than 100 µm. Even if the line width of the thin line of diffusion control masks 31, 32 is 100 µm or less, the masks can be formed to a thickness of 350 nm or more in one step of application of the ink. The interval between masks adjacent to each other is preferably 50 µm to 1500 µm. In the case where the interval is 100 µm or less, the manufacturing method of the present invention that causes no spread of ink 24 is particularly effective.

As illustrated above, the present invention includes the step of irradiating masking ink 24 with light before, during, or after application of ink 24, and therefore can prevent a spread of ink 24 on the back surface of semiconductor substrate 10 that occurs in the case where masking ink 24 is applied to the back surface of semiconductor substrate 10 without being irradiated with light or without being heated. Thus, the present invention can accurately form diffusion prevention masks 31, 32 at respective desired positions on semiconductor substrate 10, and therefore can accurately form dopant diffusion layers 12, 13 at respective desired positions. Accordingly, degradation of the characteristics of the semiconductor device such as solar cell can be suppressed.

In the case where the semiconductor device of the present invention is a solar cell, the concept of the solar cell encompasses, not only the back electrode type solar cell configured to have an electrode for first conductivity type and an electrode for second conductivity type both formed on only one surface (back surface) of the semiconductor substrate, but also solar cells configured in a variety of manners, such as: a so-called back contact solar cell (a solar cell structured so that current is extracted from the back surface opposite to the light-receiving surface of the solar cell) like MWT (Metal Wrap Through) cell (solar cell configured so that a part of an electrode is located in a through hole provided in a semiconductor substrate); and a double-sided-contact solar cell manufactured so that electrodes are formed respectively on the light-receiving surface and the back surface of a semiconductor substrate. In addition, the method for manufacturing a semiconductor device of the present invention can form highly precise diffusion control masks, and is therefore beneficial for a variety of methods for manufacturing a semiconductor device that include the step of forming a mask for controlling diffusion.

### Examples

In the following, the present invention will be described in more detail with reference to Examples. The present invention, however, is not limited to them.

### Example 1

In accordance with the first embodiment, a back electrode type solar cell was manufactured. First, a hydrophobic n-type silicon substrate was prepared from an n-type silicon wafer having a square surface with a length of one side of 100 mm and having a thickness of approximately 200 µm, by removing a layer having a damage induced by slicing, using a sodium hydroxide solution.

Next, an oxide film of 300 nm in thickness was formed as a mask on one surface of the n-type silicon substrate, by applying a masking ink and thereafter firing the ink.

In order to form a diffusion control mask on the other surface of the n-type silicon substrate, the inkjet method was used to apply a masking ink having a composition of 20% by mass of TEOS and 80% by mass of a solvent including water, and a viscosity at 25°C of 15 mPa·s. The masking ink was discharged from an inkjet head under the conditions that the discharge frequency was 20 kHz, the rate at which the inkjet head was moved was 50 mm/s, and the discharge voltage was 24 V. The n-type silicon substrate was mounted on a stage and, immediately before the masking ink was applied, a heating apparatus (heater) provided to this stage was used to set the temperature to 50°C of the surface of the n-type silicon substrate to which the ink was to be applied, and then the ink discharged from the inkjet head was applied. After this, the masking ink was dried at 200°C for 10 minutes.

Subsequently, in an ambient of a mixture of oxygen and nitrogen, the masking ink was fired at 500°C to 800°C for 30 minutes to form a diffusion control mask formed of an oxide film and having a line width of 1000 µm and a thickness of 1 µm.

Then, from an opening, a p-type dopant was diffused in a vapor phase to form a p-type dopant diffusion layer. After this, the diffusion prevention mask was removed. In order to diffuse an n-type dopant, a diffusion prevention mask was formed again in accordance with the above-described method for forming a diffusion prevention mask, in which the step of heating the masking ink was included. Subsequently, from an opening, the n-type dopant was diffused in a vapor phase to form an n-type dopant diffusion layer. After this, the diffusion prevention mask on the back surface and the mask on the front surface were removed, and a textured structure was formed on the front surface. Then, passivation films were formed on the front and back surfaces respectively. After this, the steps described in connection with the first embodiment were used to fabricate a back electrode type solar cell using the n-type silicon substrate in which the p-type dopant diffusion layer and the n-type dopant diffusion layer were formed in the back surface. The characteristics of the back electrode type solar cell were evaluated. As a result, it was confirmed that the back electrode type solar cell exhibited excellent characteristics.

### Reference Examples 1 and 2

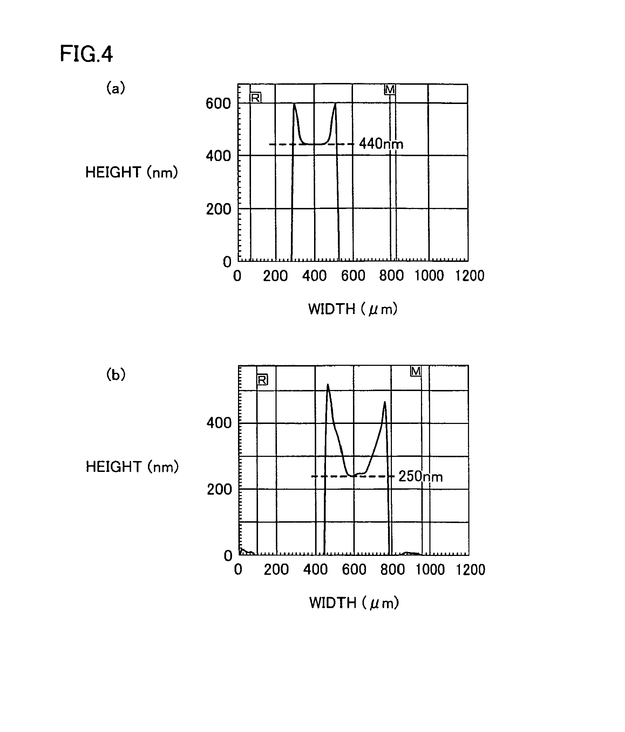

Fig. 4 (a) shows the resultant line width and thickness of a mask obtained in the following manner (Reference Example 1). Specifically, the masking ink used for Example 1 was used, the masking ink was applied and heated on an n-type silicon substrate similar to that of Example 1, under the discharge conditions and heating conditions of Example 1, and thereafter the masking ink was fired under conditions similar to those of Example 1. Fig. 4 (b) shows the resultant line width and thickness of a mask obtained in the following manner (Reference Example 2). Specifically, the mask was formed under the above-described conditions except that heating was not performed. It is seen from these results that the n-type silicon substrate can be heated to form a mask having a thin line width and a sufficient thickness.

### Reference Example 3

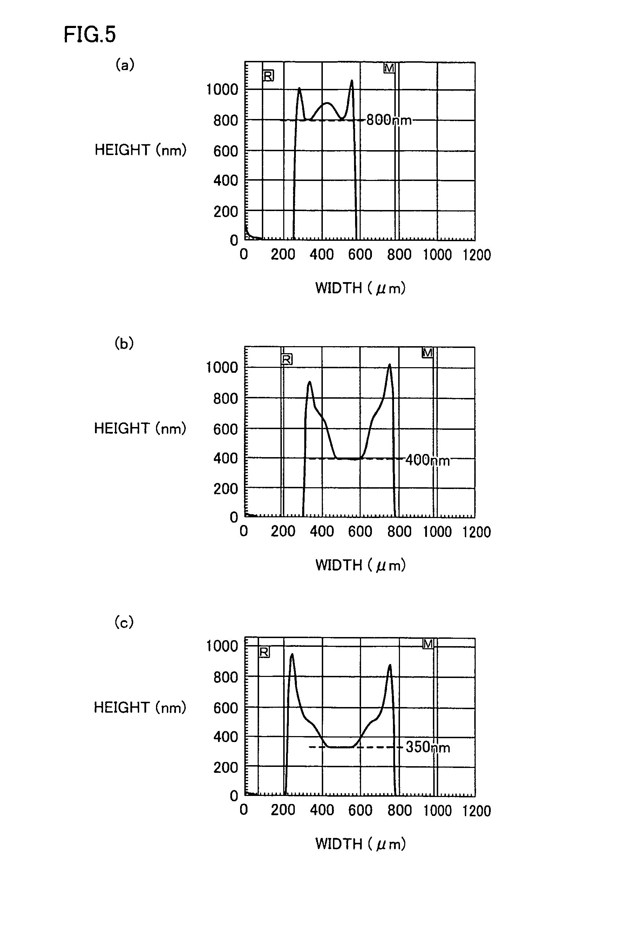

A mask was formed similarly to Reference Example 1 except that the discharge conditions were changed relative to those of Reference Example 1. Fig. 5 (a) shows the resultant line width and thickness of the mask.

The ink was discharged under the conditions that the discharge frequency was 50 kHz, the rate at which the inkjet head was moved was 50 mm/s, and the discharge voltage was 24 V. The increase of the discharge frequency is technically identical in meaning to an increase of the rate at which the inkjet head is moved.

### Reference Example 4

A mask was formed under conditions similar to those of Reference Example 3, except that heating by means of the stage was replaced with indirect heating of the applied masking ink, immediately after the masking ink was applied to the substrate by the inkjet method, using a soldering iron heated to 200°C and placed at a position at a distance of 2 mm from the back surface of the n-type silicon substrate for three seconds. Fig. 5 (b) shows the resultant line width and thickness of the mask.

### Reference Example 5

A mask was formed similarly to Reference Example 4 except that heating by means of the soldering iron was not performed. Fig. 5 (c) shows the resultant line width and thickness of the mask.

It is apparent from a comparison between the results of Examples 3 to 5 that heating was performed to thereby reduce the line width and also increase the film thickness of the mask.

While the embodiments and the examples of the present invention have been described, it is originally intended that the features of the embodiments and the examples may be combined as appropriate.

It should be construed that the embodiments and examples disclosed herein are by way of illustration in all respects, not by way of limitation. It is intended that the scope of the present invention is defined by claims, not by the description above, and encompasses all modifications and variations equivalent in meaning and scope to the claims.

### INDUSTRIAL APPLICABILITY

In accordance with the present invention, a method for manufacturing a semiconductor device can be provided by which degradation of the characteristics of the semiconductor device can stably be suppressed. In particular, the method for manufacturing a semiconductor device of the present invention may be used suitably as a method for manufacturing a solar cell.

### REFERENCE SIGNS LIST

10 semiconductor substrate; 11 passivation film; 12 first-conductivity-type dopant diffusion layer; 13 second-conductivity-type dopant diffusion layer; 14 electrode for first conductivity type; 14a power collecting electrode for first conductivity type; 15 electrode for second conductivity type; 15a power collecting electrode for second conductivity type; 16a, 17a, opening; 16b, 17b contact hole; 18 textured structure; 21 stage; 23 inkjet head; 24 ink; 25 thin line; 26 light irradiation port; 30 mask; 31, 32 diffusion control mask

## Claims

1. A method for manufacturing a semiconductor device comprising the steps of:
forming a mask (31, 32) by application of a masking ink (24) to a semiconductor substrate (10); and
forming a diffusion layer (12, 13), wherein
said method includes at least one of the step of heating said masking ink (24) and the step of irradiating said masking ink (24) with light, at at least one of a timing before, a timing during, and a timing after the application of said masking ink (24).

2. The method for manufacturing a semiconductor device according to claim 1, wherein said step of heating is performed by heating said semiconductor substrate (10).

3. The method for manufacturing a semiconductor device according to claim 1 or 2, wherein said semiconductor substrate (10) is a silicon substrate.

4. The method for manufacturing a semiconductor device according to any of claims 1 to 3, wherein said masking ink (24) contains at least one of an SiO₂ precursor and a TiO₂ precursor.

5. The method for manufacturing a semiconductor device according to claim 4, wherein said masking ink (24) contains at least one of a photo-setting resin and a thermosetting resin.

6. The method for manufacturing a semiconductor device according to any of claims 1 to 5, comprising the step of firing said masking ink (24) after said step of heating the masking ink (24) or said step of irradiating the masking ink (24) with light.
